(19) Europäisches Patentamt
European Patent Office
Office européen des brevets

(11) **EP 3 207 387 B1**

(12) **FASCICULE DE BREVET EUROPEEN**

(45) Date de publication et mention de la délivrance du brevet:
**08.05.2019 Bulletin 2019/19**

(21) Numéro de dépôt: **15753379.5**

(22) Date de dépôt: **24.08.2015**

(51) Int Cl.:
***G01R 31/36*** *(2019.01)*

(86) Numéro de dépôt international:
**PCT/EP2015/069354**

(87) Numéro de publication internationale:
**WO 2016/058738 (21.04.2016 Gazette 2016/16)**

(54) **PROCÉDÉ D'ESTIMATION D'UN ÉTAT DE SANTÉ D'UNE BATTERIE D'UN DISPOSITIF D'ALIMENTATION D'UN SYSTÈME**

VERFAHREN ZUR SCHÄTZUNG DES GESUNDHEITSZUSTANDES EINER BATTERIE IN EINER VORRICHTUNG ZUR STROMVERSORGUNG EINES SYSTEMS

METHOD FOR ESTIMATING THE STATE OF HEALTH OF A BATTERY IN A DEVICE SUPPLYING POWER TO A SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.10.2014 FR 1459820**

(43) Date de publication de la demande:
**23.08.2017 Bulletin 2017/34**

(73) Titulaire: **Sagemcom Energy & Telecom SAS 92500 Rueil-Malmaison (FR)**

(72) Inventeurs:
• **BESSIENE, Daniel**
**F-92500 Rueil Malmaison (FR)**
• **MOY, Philippe**
**F-92500 Rueil Malmaison (FR)**
• **DURAND, Guillaume**
**F-92500 Rueil Malmaison (FR)**

(74) Mandataire: **Decorchemont, Audrey Véronique Christèle et al**
**CABINET BOETTCHER**
**16, rue Médéric**
**75017 Paris (FR)**

(56) Documents cités:
**JP-A- 2011 153 951     US-A1- 2005 225 301**
**US-B1- 6 304 471**

**Description**

L'invention concerne un procédé d'estimation d'un état de santé, (plus connu sous le terme SoH pour State of Health en anglais), d'une batterie d'un dispositif d'alimentation d'un système.

ARRIERE-PLAN TECHNOLOGIQUE DE L'INVENTION

Les sites isolés, comme les stations relais, comportent usuellement une source d'alimentation principale éventuellement associée à une ou plusieurs sources d'alimentations secondaires qui permettent d'alimenter un système externe. Ils comportent en outre une batterie de secours permettant d'alimenter le système lorsque les sources d'alimentations ne peuvent plus assurer une telle alimentation.

La batterie est donc rarement sollicitée pour alimenter le système. De la sorte si la batterie s'avère défaillante ou moins performante, du fait notamment de son vieillissement, cela n'est détecté que tardivement au moment où elle devient réellement opérationnelle.

Afin de pallier à cet inconvénient, il est connu d'envoyer régulièrement un opérateur sur le site isolé tester la batterie. Pour cela, l'opérateur vient déconnecter la batterie du système externe pour provoquer volontairement sa décharge dans une résistance. L'opérateur étudie alors la capacité de décharge de la batterie par rapport à la capacité de décharge d'une batterie identique neuve et en déduit l'état de santé de la batterie afin de décider s'il convient ou non de remplacer la batterie.

Toutefois, le test d'une seule batterie dure environ quatre heures de sorte que le site demeure privé de sa batterie pendant ce laps de temps ce qui s'avère gênant en cas de défaillance de la source d'alimentation principale. En outre, ceci engendre des signaux parasites dans le dispositif d'alimentation.

Le brevet US 6 304 471 (CHALASANI SUBHAS CHANDRA ET AL, 16 octobre 2001) décrit un procédé d'estimation d'une capacité d'une batterie de secours d'une centrale électrique.

OBJET DE L'INVENTION

Un but de l'invention est de proposer un procédé d'estimation d'un état de santé d'une batterie qui soit moins perturbant pour le système alimenté par ladite batterie.

BREVE DESCRIPTION DE L'INVENTION

En vue de la mise en oeuvre de ce but, on propose un procédé d'estimation d'un état de santé d'une batterie d'un dispositif d'alimentation d'un système, le dispositif d'alimentation comprenant au moins une source d'alimentation principale alimentant nominalement ledit système, la batterie étant couplée à ladite source d'alimentation principale et audit système de sorte à pouvoir alimenter le système lors d'une coupure d'alimentation par ladite source d'alimentation principale, le procédé comportant l'étape de :

- couper volontairement l'alimentation du système par la source d'alimentation principale, la batterie demeurant couplée au système externe pour alimenter ledit système externe,
- déterminer une puissance délivrée par la batterie audit système et mesurer une tension délivrée par la batterie audit système,
- rétablir l'alimentation du système par la source d'alimentation principale avant une décharge totale de la batterie,
- à partir de la puissance délivrée, déterminer un temps de décharge totale théorique de la batterie,
- à partir de la tension mesurée au cours de la décharge partielle, déterminer une courbe de décharge partielle de la batterie et extrapoler ladite courbe pour en déduire une courbe de décharge totale de la batterie et estimer ainsi un temps de décharge totale réel de la batterie, le rapport temps de décharge totale réel sur temps de décharge totale théorique donnant l'état de santé de la batterie.

Ainsi, grâce à la coupure volontaire de l'alimentation du système par la source d'alimentation principale, la batterie va venir alimenter le système et donc se décharger naturellement dans le système. Le procédé selon l'invention permet donc avantageusement d'estimer l'état de santé d'une batterie directement à partir de données mesurées en fonctionnement opérationnel de la batterie, c'est-à-dire comme s'il y avait une réelle coupure d'alimentation par la source d'alimentation et que le système n'était alimenté que par la batterie, sans déconnexion de la batterie au système.

Le procédé selon l'invention évite ainsi de perturber le système et le dispositif d'alimentation lors de sa mise en oeuvre puisque la batterie est en fonctionnement normal et ne transmet pas de signal parasite au reste du dispositif d'alimentation ou au système lors de sa décharge partielle.

En outre, le procédé s'avère simple et rapide à mettre en oeuvre puisqu'il n'est pas nécessaire de modifier la connexion de la batterie pour en étudier sa décharge et que de plus seule une décharge partielle de la batterie est étudiée.

BREVE DESCRIPTION DES DESSINS

L'invention sera mieux comprise à la lumière de la description qui suit d'un mode de mise en oeuvre particulier non limitatif de l'invention. Il sera fait référence aux figures ci-jointes, parmi lesquelles :

- la figure 1 illustre schématiquement une partie du dispositif d'alimentation pour la mise en oeuvre d'un procédé selon l'invention ainsi que le système qu'il alimente,
- la figure 2 est un schéma représentant les principales étapes de la décharge partielle de la batterie du dispositif illustré à la figure 1,
- la figure 3 est un schéma illustrant les étapes de détermination de l'état de santé de la batterie du dispositif représenté à la figure 1, une fois la décharge partielle schématisée à la figure 2 terminée,
- la figure 4 est un graphique représentant différentes courbes de décharges totales théoriques de la batterie du dispositif illustré à la figure 1 selon différents régimes de décharge,
- la figure 5 est un graphique représentant la courbe de décharge totale théorique et la courbe de décharge totale réelle de la batterie du dispositif illustré à la figure 1.

DESCRIPTION DETAILLEE DE L'INVENTION

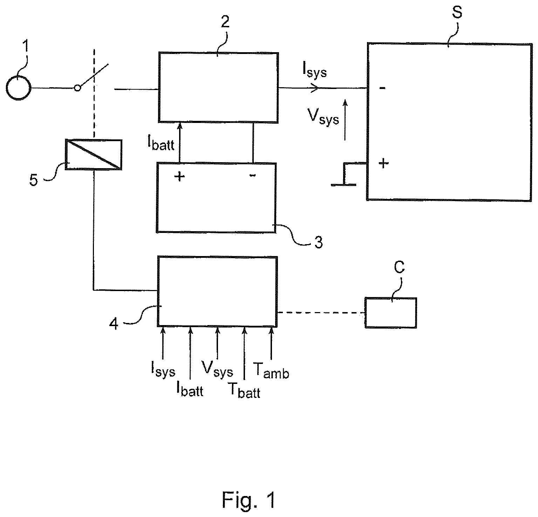

En référence à la figure 1, le procédé selon l'invention est mis en oeuvre à partir d'un dispositif d'alimentation implanté sur un site comme une station relais. Le dispositif d'alimentation comporte une source d'alimentation principale 1, comme par exemple un réseau électrique ou un groupe électrogène, qui délivre une alimentation en courant alternatif. Le dispositif d'alimentation comporte en outre un organe d'adaptation 2 permettant de convertir ladite alimentation en courant alternatif en une alimentation en courant continu apte à alimenter un système externe S.

De façon connue en soi, le dispositif d'alimentation comporte une batterie 3 raccordée à l'organe d'adaptation 2. L'organe d'adaptation 2 joue donc ici également le rôle de chargeur de la batterie 3 et est ainsi configuré pour autoriser un chargement de la batterie 3 via la puissance électrique fournie par la source d'alimentation principale 1. La batterie 3 est donc couplée à ladite source 1 et au système externe S via l'organe d'adaptation 2 de sorte à pouvoir alimenter le système externe S si besoin.

En effet, la source d'alimentation principale 1 alimente nominalement le système externe S. Toutefois, lorsque l'alimentation du système externe S via la source d'alimentation principale 1 est coupée, la batterie 3 est configurée pour alimenter le système externe S le temps que l'alimentation par la source d'alimentation principale 1 soit rétablie.

De préférence, le dispositif d'alimentation comporte un contrôleur 4 qui est géré à distance par un ordinateur C déporté du site. La communication entre le contrôleur 4 et l'ordinateur C est assurée par exemple par Internet, par un réseau GSM, par un réseau 3G ... De façon particulière, le contrôleur 4, soit directement soit via l'ordinateur C, a accès à une base de données répertoriant les différentes batteries des différents sites que doit surveiller un opérateur. Cette base de données répertorie notamment le type, c'est-à-dire le modèle, des batteries ainsi que l'agencement des batteries (connexion en parallèle ou non). Cette base de données comporte en outre les données fournies par le constructeur caractérisant chaque type de batterie.

Par ailleurs, le dispositif d'alimentation comporte différents capteurs (non représentés ici) qui sont tous reliés au contrôleur 4. Ici, le dispositif comporte un capteur de mesure de la tension $V_{sys}$ délivrée par le dispositif d'alimentation au système S, un capteur de mesure de l'intensité du courant $I_{sys}$ délivré par la dispositif d'alimentation au système S, un capteur de mesure de l'intensité du courant $I_{batt}$ délivré par la batterie 3 à l'organe d'adaptation 2, un capteur mesurant la température de la batterie $T_{batt}$ et un capteur mesurant la température ambiante $T_{amb}$ c'est-à-dire la température régnant à l'extérieur du dispositif d'alimentation.

Le dispositif d'alimentation comporte ici un relai 5 qui est configuré pour permettre la coupure de l'alimentation du système S par la source d'alimentation principale 1 et qui est commandé par le contrôleur 4.

Le procédé selon l'invention va être à présent décrit.

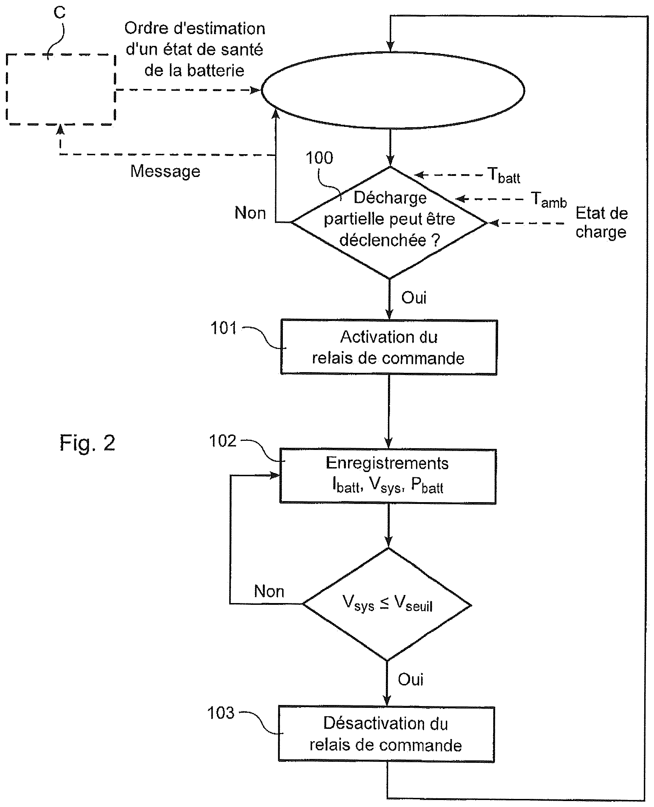

En référence aux figures 1 et 2, de préférence, en réponse à un ordre d'estimation de l'état de santé de la batterie 3 transmis par l'ordinateur C au contrôleur 4, le contrôleur 4 s'assure que la décharge partielle de la batterie 3 peut être déclenchée. Il s'agit de l'étape référencée 100 à la figure 2.

Ici le contrôleur 4 estime dans un premier temps si la batterie 3 est complètement chargée. Typiquement, la batterie 3 est considérée comme suffisamment chargée si l'organe d'adaptation 2 qui l'alimente est en charge d'entretien (plus connu sous le terme anglais de « floating mode ») depuis au moins deux jours.

Le contrôleur 4 estime ensuite dans un deuxième temps si les conditions de température ambiante et de température de la batterie 3 sont acceptables. Typiquement, de telles conditions sont acceptables si la température de la batterie $T_{batt}$ est dans un intervalle donné et si la température ambiante $T_{amb}$ est dans un intervalle donné, les deux intervalles étant prédéfinis et paramétrables par l'opérateur. En effet, en cas de grand froid, il y a une perte systématique mais temporaire de capacité de charge/décharge d'une batterie due à la température. Mettre en oeuvre le procédé selon l'invention lorsque la température ambiante $T_{amb}$ est très basse et/ou que la température de la batterie $T_{batt}$ est très basse ne permet donc pas d'estimer le réel état de santé de la batterie 3 de sorte qu'il n'est pas intéressant de lancer le reste du procédé selon l'invention dans ce cas-là.

Si le contrôleur 4 détermine que le reste dudit procédé ne peut pas être mis en oeuvre, il envoie un message correspondant à l'ordinateur C.

Si le contrôleur 4 détermine que la batterie 3 est complètement chargée et que les conditions de températures sont acceptables, c'est-à-dire que le reste dudit procédé peut être mis en oeuvre, le contrôleur 4 met en oeuvre l'étape suivante 101 dudit procédé en commandant une activation du relais de commande 5 afin de provoquer volontairement une coupure de l'alimentation du système S par la source d'alimentation principale 1. De la sorte, le système S demeure toujours alimenté mais par la batterie 3 en place de la source d'alimentation principale 1. La batterie 3 commence alors à se décharger.

Au cours de l'étape 102 de décharge partielle de la batterie 3, le contrôleur 4 enregistre des données fournies par les différents capteurs du dispositif d'alimentation. En particulier, le contrôleur 4 enregistre la tension $V_{sys}$ délivrée par le dispositif d'alimentation au système S, c'est-à-dire ici la tension délivrée par la batterie 3 au système S, tout au long de la décharge partielle de la batterie 3. Le contrôleur 4 enregistre également ici l'intensité du courant $I_{batt}$ délivré par la batterie 3 à l'organe d'adaptation 2 tout au long de la décharge partielle de la batterie 3. En outre, le contrôleur 4 enregistre également une puissance délivrée $P_{batt}$ par la batterie 3 audit système S. Ladite puissance $P_{batt}$ est ici théoriquement constante, le système S fonctionnant à puissance constante, bien que la tension et l'intensité délivrées par la batterie 3 soient variables dans le temps. De la sorte, la puissance délivrée $P_{batt}$ est ici déterminée une seule fois en début de décharge partielle de la batterie 3 grâce aux informations de tension $V_{sys}$ et d'intensité $I_{batt}$ délivrées par la batterie 3 en début de décharge partielle.

Avant une décharge totale de la batterie 3, le contrôleur 4 ordonne, au cours de l'étape 103, une désactivation du relais de commande 5 afin de provoquer volontairement un rétablissement de l'alimentation du système S par la source d'alimentation principale 1. Ceci marque la fin de la décharge partielle de la batterie 3.

De préférence, cet ordre s'effectue de façon automatique sans que l'opérateur ait besoin d'intervenir et de requérir une fin de décharge partielle via l'ordinateur C.

De façon particulière, le contrôleur 4 ordonne une désactivation du relais de commande 5 lorsque la tension de la batterie $V_{sys}$ devient inférieure à une tension seuil donnée $V_{seuil}$. Ladite tension seuil $V_{seuil}$ est par exemple prédéfinie et paramétrable par l'opérateur lui-même. Toutefois, ladite tension seuil $V_{seuil}$ ne peut évidemment pas être inférieure à la tension d'arrêt $V_{stop}$ de la batterie, tension définie et fournie par le constructeur qui correspond à la tension minimale de fonctionnement de la batterie en-dessous de laquelle il y a dégradation de la batterie. Ladite tension seuil $V_{seuil}$ est en outre avantageusement choisie de sorte à être supérieure à une tension minimale requise que doit délivrer la batterie 3 au système S pour que le système S puisse fonctionner lorsqu'il n'est alimenté que par la batterie 3.

Ainsi, une condition d'arrêt de la décharge partielle de la batterie 3 est prévue pour éviter qu'une décharge trop longue ne pénalise le système S.

De la sorte, la décharge partielle de la batterie 3 pour la mise en oeuvre du procédé selon l'invention ne perturbe pas le fonctionnement du système S.

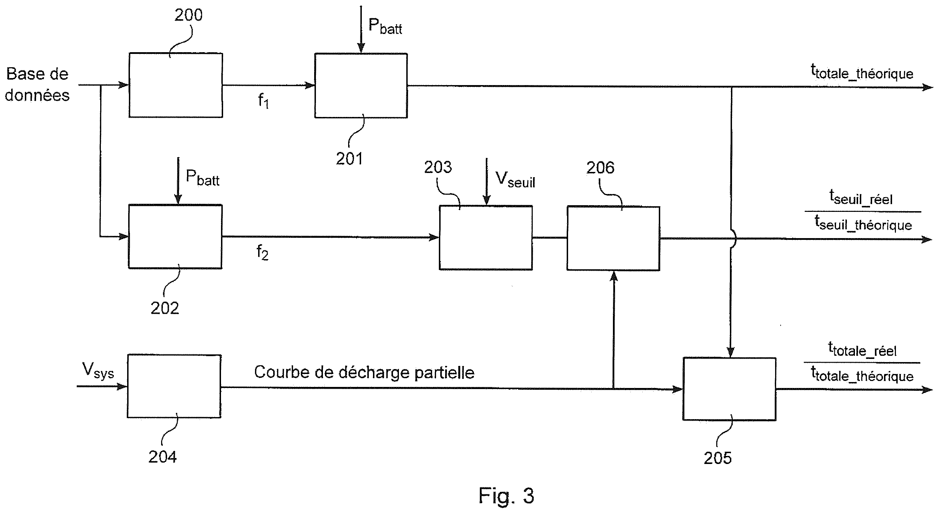

En référence aux figures 1, 3 et 5, les données enregistrées par le contrôleur 4 sont ensuite traitées, soit directement par le contrôleur 4 soit par l'ordinateur C consécutivement à la transmission des données par le contrôleur 4 à l'ordinateur C, pour déterminer l'état de santé de la batterie 3.

A cet effet, un temps de décharge totale théorique $t_{totale\_théorique}$ de la batterie 3 est calculé.

Pour cela, à partir de données donnant l'énergie que peut délivrer une batterie en fonction d'une puissance délivrée, données fournies par la base de données et qui dépendent du type de batterie considérée et de l'agencement de la batterie considérée, on détermine au cours d'une étape 200 une fonction $f_1$ donnant le temps de décharge t en fonction d'une puissance délivrée P.

Typiquement, la fonction est de type :

$$f_1(t) = b.P^a \quad (1)$$

où a et b sont déterminés grâce à un algorithme classique d'ajustement de fonction par la méthode des moindres carrés à partir des données précitées,

P est la puissance délivrée par la batterie, et

t est le temps de décharge.

Une fois calculés, les coefficients a et b sont de préférence enregistrés dans la base de données pour ne pas à être déterminés à chaque nouvelle mise en oeuvre du procédé selon l'invention.

A partir de ladite fonction (1) et de la puissance délivrée $P_{batt}$ qui a été déterminée en début de décharge partielle de la batterie 3, il est alors possible de calculer le temps de décharge totale théorique $t_{totale\_théorique}$ de la batterie 3 délivrant ladite puissance délivrée donnée $P_{batt}$ au cours d'une étape 201. Ce temps de décharge totale théorique $t_{totale\_théorique}$ correspond en réalité au temps qu'il faudrait pour décharger complètement une batterie neuve du même type que la batterie 3, avec le même agencement, fournissant la même puissance constante donnée $P_{batt}$.

Toujours dans le but de déterminer l'état de santé de la batterie 3, un temps de décharge totale réel $t_{totale\_réel}$ de la batterie 3 est également déterminé.

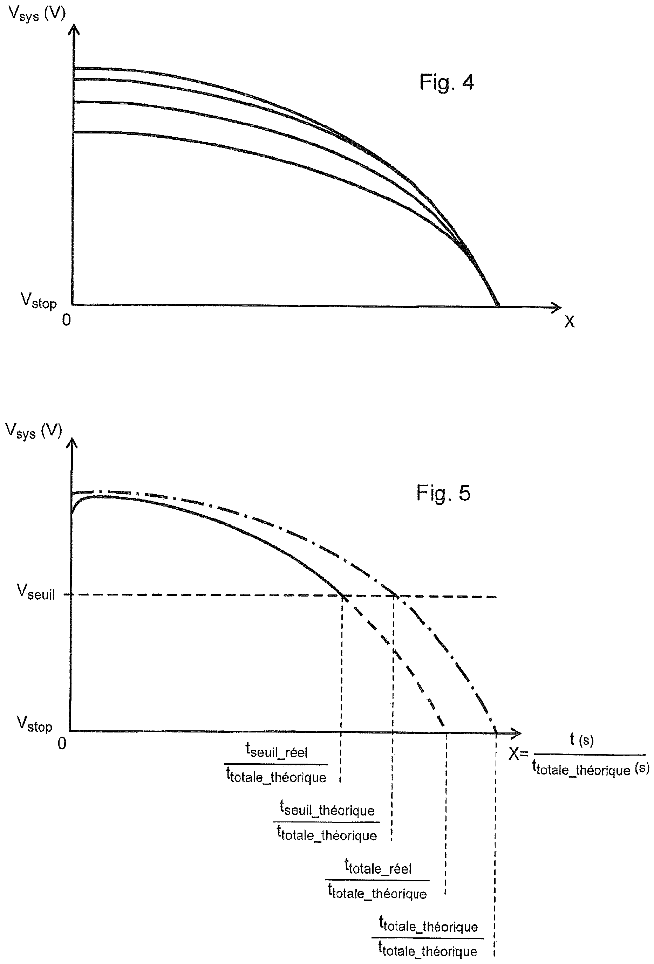

A cet effet, suite à l'étape de décharge partielle 102, une courbe de décharge partielle de la batterie 3 est tracée, au cours de l'étape 204, comme illustrée en trait plein à la figure 5. Ici, la courbe de décharge partielle représente la tension délivrée par la batterie $V_{sys}$ en fonction de x c'est-à-dire du temps de décharge divisé par le temps de décharge totale théorique $t_{totale\_théorique}$ qui a été déterminée précédemment.

La courbe de décharge partielle réelle est alors extrapolée, lors de l'étape 205, afin de pouvoir modéliser une courbe de décharge totale réelle de la batterie (représentée en tirets sur la figure 5). Pour mettre en oeuvre l'extrapolation, on utilise par exemple un algorithme classique d'extrapolation de courbe. Cet algorithme est de préférence associé à un coefficient correcteur qui est déterminé expérimentalement et qui permet d'améliorer la précision de l'extrapolation.

De cette courbe extrapolée, il est alors possible de déduire le rapport temps de décharge totale réel sur le temps de décharge totale théorique de la batterie $t_{totale\_réel}/t_{totale\_théorique}$ qui est l'abscisse du point de la courbe extrapolée ayant pour ordonnée $V_{stop}$. Ce rapport correspond à la valeur de l'état de santé SoH de la batterie.

De préférence, si ledit état de santé est inférieur à un seuil donné, une alarme est émise via le contrôleur 4 et l'ordinateur C à l'attention de l'opérateur. Le seuil prédéterminé est par exemple prédéfini et paramétrable par l'opérateur lui-même.

De façon particulière, on détermine également une autonomie réelle de la batterie 3. A cet effet, connaissant l'équation de la courbe de décharge totale réelle grâce à l'extrapolation, par un algorithme classique comme la méthode de dichotomie ou la méthode Newton, il est possible de calculer le temps de décharge t en fonction de la tension délivrée $V_{sys}$ pour la puissance délivrée $P_{batt}$ et en particulier le temps de décharge t nécessaire pour aboutir à une tension particulière délivrée au système S en dessous de laquelle le système S ne peut plus fonctionner. Ceci donne l'autonomie de la batterie 3.

Le procédé selon l'invention s'avère donc simple et rapide à mettre en oeuvre. Il permet notamment de ne pas perturber le système S et le reste du dispositif d'alimentation en autorisant l'étude de la batterie 3 en fonctionnement opérationnel. En outre il peut être mis en oeuvre à distance ce qui évite une intervention manuelle sur le site représentant un gain de temps et d'argent.

De préférence, le procédé selon l'invention comporte une étape d'estimation d'un état de santé « partiel » SoH' de la batterie 3.

A cet effet, on a recours à des données portant sur des courbes de décharges totales que l'on a pu retirer de la base de données et qui dépendent du type de batterie considérée et de l'agencement de la batterie considérée. Ces données comportent plus précisément des courbes de décharges totales donnant la tension de la batterie considérée en fonction du temps pour différents régimes de décharge, i.e. pour différentes valeurs constantes de courant délivré par la batterie, jusqu'à décharge totale de la batterie. Ces données peuvent être fournies par le constructeur ou mesurées de façon expérimentale en laboratoire sur des batteries neuves.

A partir de ces données, on détermine des fonctions donnant une décharge totale théorique pour différentes puissances délivrées et notamment, au cours d'une étape 202, pour la puissance délivrée donnée $P_{batt}$.

Typiquement, chaque fonction est de type :

$$f_2(V_{sys}) = a_o + a_1 x + a_2 x^2 + a_3 x^3 + a_4 x^4 \quad (2)$$

où $a_0$, $a_1$, $a_2$, $a_3$, $a_4$, $a_5$ sont déterminés grâce à un algorithme classique d'ajustement de fonction par la méthode des moindres carrés à partir des données précitées, x est le temps de décharge divisé par le temps de décharge totale théorique de la batterie c'est-à-dire le temps que la batterie neuve met pour se décharger totalement, et $V_{sys}$ est la tension délivrée par la batterie. La courbe de décharge totale théorique correspondante à $P_{batt}$ définie par la fonction $f_2$ a également été représentée sur la figure 5 en pointillés.

Une fois calculés, les coefficients $a_0$, $a_1$, $a_2$, $a_3$, $a_4$, $a_5$ sont de préférence enregistrés dans la base de données pour ne pas à être déterminés à chaque nouvelle mise en oeuvre du procédé selon l'invention.

De telles fonctions (2) permettent de tracer des courbes de décharges totales théoriques pour différents régimes de décharges comme illustrées à la figure 4 et notamment pour la puissance délivrée $P_{batt}$. Lesdites fonctions (2) permettent ainsi de calculer la tension délivrée par la batterie $V_{sys}$ en fonction du pourcentage de la capacité déchargée de la batterie et ce pour plusieurs régimes de décharges dont celui de la puissance délivrée $P_{batt}$. En outre, par un algorithme classique comme la méthode de dichotomie ou la méthode de Newton, de telles fonctions (2) permettent également de calculer le pourcentage de capacité déchargée de la batterie en fonction de la tension délivrée $V_{sys}$ et ce pour plusieurs régimes de décharges dont celui de la puissance délivrée $P_{batt}$ .

Dans le cas présent, à l'aide de la fonction (2) pour la puissance délivrée $P_{batt}$, on détermine au cours de l'étape 203 le temps de décharge théorique nécessaire pour atteindre la tension seuil $t_{seuil\_théorique}$.

Par ailleurs on connait le temps de décharge réel nécessaire pour atteindre la tension seuil $t_{seuil-réel}$ grâce à l'étape de décharge partielle 102. Il est dès lors possible de calculer, lors de l'étape 206, le rapport temps de décharge seuil réel sur le temps de décharge seuil théorique de la batterie $t_{seuil\_réel}/t_{seuil\_théorique}$. Ce rapport correspond à la valeur de l'état de santé « partiel » SoH' de la batterie 3.

Cette valeur de l'état de santé « partiel » SoH' permet d'avoir une information supplémentaire sur l'état de la batterie 3 et permet notamment d'avoir un ordre d'idée de la valeur de l'état de santé final SoH.

Bien entendu l'invention n'est pas limitée à la mise en oeuvre décrite et on peut y apporter des variantes sans sortir du cadre de l'invention tel que défini par les revendications.

Le dispositif d'alimentation pourra avoir une autre configuration que celle illustrée. Par exemple, le dispositif d'alimentation pourra comporter des sources d'alimentation secondaires, comme des sources d'énergies renouvelables, en plus de la source d'alimentation principale.

Bien qu'ici, la puissance délivrée donnée soit calculée une unique fois en début de décharge partielle de la batterie, on pourra déterminer ladite puissance délivrée en mesurant la puissance délivrée par la batterie tout au long de sa décharge partielle puis en moyennant ladite puissance sur l'intervalle de temps de la décharge partielle. Ceci permettra de prendre en compte les éventuels changements que pourrait présenter la valeur de la puissance délivrée théoriquement constante.

D'autres conditions d'arrêts à la décharge partielle que la tension seuil pourront être prévues. Par exemple, le contrôleur pourra commander une désactivation du relais de commande lorsqu'un temps de décharge atteindra un temps seuil. En variante, le contrôleur pourra commander une désactivation du relais de commande lorsque la capacité déchargée par la batterie deviendra supérieure à une capacité seuil ou encore lorsqu'une énergie déchargée par la batterie deviendra supérieure à une énergie seuil. Le choix du seuil dépendra des circonstances. Par exemple, un opérateur pourra préférer de limiter la quantité d'énergie déchargée lors de la décharge partielle de la batterie afin de préserver un système opérationnel même en cas de panne électrique survenant juste après la décharge partielle de la batterie. Les différentes valeurs seuils pourront être prédéfinies par un opérateur. Le fait de rendre les valeurs seuils paramétrables par un opérateur permet de s'adapter à différentes conditions. Par exemple la tension seuil correspond généralement à la tension minimale requise par le système alimenté. La valeur de tension seuil peut donc varier d'un site à un autre d'où l'intérêt de rendre cette valeur paramétrable pour l'opérateur. Bien qu'ici une seule condition d'arrêt de la décharge partielle soit prévue, un plus grand nombre de conditions d'arrêts pourra être prévu pour une même décharge partielle.

D'autres paramètres que l'état de santé, l'état de santé « partielle » ou l'autonomie de la batterie pourront être calculés à l'issue de la décharge partielle comme une date de remplacement de la batterie.

Le dispositif d'alimentation pourra ne pas comporter de contrôleur et être directement contrôlé à distance par un ordinateur distant.

## Revendications

1. Procédé d'estimation **caractérisé en ce qu'**il s'agit d'un procédé d'estimation d'un rapport temps de décharge totale réel sur temps de décharge totale théorique donnant l'état de santé d'une batterie (3) d'un dispositif d'alimentation d'un système (S), le dispositif d'alimentation comprenant au moins une source d'alimentation principale (1) alimentant nominalement ledit système (S), la batterie étant couplée à ladite source d'alimentation principale et audit système de sorte à pouvoir alimenter le système lors d'une coupure d'alimentation par ladite source d'alimentation principale, le procédé comportant l'étape de :

- couper (101) volontairement l'alimentation du système par la source d'alimentation principale, la batterie demeurant couplée au système externe pour alimenter ledit système externe,
- déterminer (102) une puissance délivrée ($P_{batt}$) par la batterie audit système et mesurer une tension ($V_{syst}$) délivrée par la batterie audit système,
- rétablir (103) l'alimentation du système par la source d'alimentation principale avant une décharge totale de la batterie,
- à partir de la puissance délivrée, déterminer (200, 201) un temps de décharge totale théorique de la batterie

($t_{totale\_théorique}$),

- à partir de la tension mesurée au cours de la décharge partielle, déterminer (204) une courbe de décharge partielle de la batterie et extrapoler (205) ladite courbe pour en déduire une courbe de décharge totale de la batterie et estimer ainsi un temps de décharge totale réel ($t_{totale\_réel}$) de la batterie, le rapport temps de décharge totale réel sur temps de décharge totale théorique donnant l'état de santé de la batterie.

2. Procédé selon la revendication 1, dans lequel la puissance délivrée ($P_{batt}$) est déterminée une seule fois en début de décharge de la batterie (3).

3. Procédé selon la revendication 1, dans lequel on rétablit (103) l'alimentation du système (S) par la source d'alimentation principale (1) lorsque la tension de la batterie ($V_{sys}$) descend en-dessous d'une tension seuil ($V_{seuil}$).

4. Procédé selon la revendication 3, comportant en outre une étape (206) d'estimation d'un état de santé partiel de la batterie (3) par un calcul du rapport du temps de décharge réel pour atteindre la tension seuil sur un temps de décharge théorique pour atteindre ladite tension seuil.

5. Procédé selon la revendication 1, comportant une étape (100) de vérification préalable que la coupure volontaire de l'alimentation du système (S) par la source d'alimentation principale (1) puisse être déclenchée.

6. Procédé selon la revendication 5, dans lequel l'étape de vérification (100) valide le déclenchement de la coupure volontaire de l'alimentation du système (S) par la source d'alimentation principale (1) lorsque la batterie (3) est complètement chargée et/ou qu'une température de la batterie ($T_{batt}$) est dans un intervalle donné et/ou qu'une température ambiante ($T_{amb}$) est dans un intervalle donné.

7. Procédé selon la revendication 1, dans lequel on détermine le temps de décharge théorique ($t_{totale\_théorique}$) de la batterie (3) en :

   - déterminant (200) une fonction donnant le temps de décharge en fonction d'une puissance délivrée ($P_{batt}$), et
   - calculant (201), à partir de ladite fonction et de la puissance délivrée ($P_{batt}$), le temps de décharge totale théorique de la batterie ($t_{totale\_théorique}$).

8. Procédé selon la revendication 1, comportant en outre une étape de calcul de l'autonomie de la batterie (3) à partir de ladite courbe extrapolée.

9. Procédé selon la revendication 1, comportant une étape d'actionnement d'une alarme si l'état de santé de la batterie (3) est inférieur à un seuil donné.

10. Procédé selon la revendication 1, dans lequel le dispositif d'alimentation comporte un relai de commande (5) qui permet la coupure de l'alimentation du système (S) par la source d'alimentation principale (1) et qui est commandé par un contrôleur (4) du dispositif d'alimentation, le contrôleur étant commandé à distance pour entraîner l'activation ou la désactivation du relai de commande.

11. Dispositif d'alimentation configuré pour mettre en oeuvre le procédé selon l'une des revendications précédentes, le dispositif comprenant :

   - la batterie (3),
   - un organe d'adaptation (2) couplant la batterie à la source d'alimentation principale (1) d'une part et au système (S) d'autre part,
   - un relai de commande (5) permettant la coupure de l'alimentation du système par la source d'alimentation principale,
   - un contrôleur (4) commandant le relai de commande, le contrôleur comprenant des moyens de communication à distance avec un ordinateur (C),
   - au moins un capteur de mesure d'une tension délivrée par le dispositif d'alimentation ($V_{sys}$) au système et un capteur de mesure d'une intensité ($I_{batt}$) délivrée par la batterie à l'organe d'adaptation.

**Patentansprüche**

1. Schätzverfahren, **dadurch gekennzeichnet, dass** es sich um ein Verfahren zum Schätzen eines Verhältnisses einer tatsächlichen Gesamtentladungszeit zu einer theoretischen Gesamtentladungszeit handelt, das den Gesundheitszustand einer Batterie (3) einer Versorgungsvorrichtung eines Systems (S) angibt, wobei die Versorgungsvorrichtung mindestens eine Hauptversorgungsquelle (1) umfasst, die das genannte System (S) nominal versorgt, wobei die Batterie mit der genannten Hauptversorgungsquelle und dem genannten System derart gekoppelt ist, dass sie das System während einer Unterbrechung der Versorgung durch die genannte Hauptversorgungsquelle versorgen kann, wobei das Verfahren den Schritt umfasst:

   - absichtliches Unterbrechen (101) der Versorgung des Systems durch die Hauptversorgungsquelle, wobei die Batterie mit dem externen System gekoppelt bleibt, um das genannte externe System zu versorgen,
   - Bestimmen (102) einer von der Batterie an das System gelieferten Leistung ($P_{batt}$) und Messen einer von der Batterie an das genannte System gelieferten Spannung ($V_{syst}$),
   - Wiederherstellen (103) der Versorgung des Systems durch die Hauptversorgungsquelle vor einer Gesamtentladung der Batterie,
   - Bestimmen (200, 201) einer theoretischen Gesamtentladungszeit ($t_{totale\_théorique}$) der Batterie anhand der gelieferten Leistung,
   - Bestimmen (204) einer Teilentladungskurve der Batterie anhand der während der Teilentladung gemessenen Spannung und Extrapolieren (205) der genannten Kurve, um daraus eine Gesamtentladungskurve der Batterie herzuleiten und so eine tatsächliche Gesamtentladungszeit ($t_{totale\_réel}$) der Batterie zu schätzen, wobei das Verhältnis von tatsächlicher Gesamtentladungszeit zu theoretischer Gesamtentladungszeit den Gesundheitszustand der Batterie angibt.

2. Verfahren nach Anspruch 1, bei dem die gelieferte Leistung ($P_{batt}$) nur einmal zu Beginn der Entladung der Batterie (3) bestimmt wird.

3. Verfahren nach Anspruch 1, bei dem man die Versorgung des Systems (S) durch die Hauptversorgungsquelle (1) wiederherstellt (103), wenn die Spannung der Batterie ($V_{sys}$) unter eine Schwellwertspannung ($V_{seuil}$) sinkt.

4. Verfahren nach Anspruch 3, ferner umfassend einen Schritt (206) des Schätzens eines Teilgesundheitszustandes der Batterie (3) durch eine Berechnung des Verhältnisses der tatsächlichen Entladungszeit zum Erreichen der Schwellwertspannung zu einer theoretischen Entladungszeit zum Erreichen der genannten Schwellwertspannung.

5. Verfahren nach Anspruch 1, umfassend einen Schritt (100) des vorherigen Verifizierens, ob das absichtliche Unterbrechen der Versorgung des Systems (S) durch die Hauptversorgungsquelle (1) ausgelöst werden kann.

6. Verfahren nach Anspruch 5, bei dem der Verifizierungsschritt (100) das Auslösen des absichtlichen Unterbrechens der Versorgung des Systems (S) durch die Hauptversorgungsquelle validiert, wenn die Batterie (3) vollständig geladen ist und/oder wenn eine Temperatur ($T_{batt}$) der Batterie in einem gegebenen Intervall liegt und/oder wenn eine Umgebungstemperatur ($T_{amb}$) in einem gegebenen Intervall liegt.

7. Verfahren nach Anspruch 1, bei dem man die theoretische Entladungszeit ($t_{totale\_théorique}$) der Batterie (3) bestimmt, indem:

   - eine Funktion bestimmt wird (200), die die Entladungszeit in Abhängigkeit von einer gelieferten Leistung ($P_{batt}$) angibt, und
   - anhand der genannten Funktion und der gelieferten Leistung ($P_{batt}$) die theoretische Gesamtentladungszeit ($t_{totale\_théorique}$) der Batterie berechnet wird (201) .

8. Verfahren nach Anspruch 1, ferner umfassend den Schritt des Berechnens der Lebensdauer der Batterie (3) anhand der genannten extrapolierten Kurve.

9. Verfahren nach Anspruch 1, umfassend einen Schritt des Auslösens eines Alarms, wenn der Gesundheitszustand der Batterie (3) unter einem gegebenen Schwellwert liegt.

10. Verfahren nach Anspruch 1, bei dem die Versorgungsvorrichtung ein Steuerrelais (5) umfasst, das das Unterbrechen der Versorgung des Systems (S) durch die Hauptversorgungsquelle (1) ermöglicht und das von einem Steuergerät (4) der Versorgungsvorrichtung gesteuert wird, wobei das Steuergerät ferngesteuert wird, um die Aktivierung oder die Deaktivierung des Steuerrelais zu bewirken.

**11.** Versorgungsvorrichtung, die ausgebildet ist, um das Verfahren nach einem der vorhergehenden Ansprüche durchzuführen, wobei die Vorrichtung umfasst:

- die Batterie (3),
- ein Anpassungselement (2), das die Batterie mit der Hauptversorgungsquelle (1) einerseits und dem System (S) andererseits koppelt,
- ein Steuerrelais (5), das das Unterbrechen der Versorgung des Systems durch die Hauptversorgungsquelle ermöglicht,
- ein Steuergerät (4), das das Steuerrelais steuert, wobei das Steuergerät Fernkommunikationsmittel zur Fernkommunikation mit einem Rechner (C) umfasst,
- mindestens einen Messsensor zum Messen einer von der Versorgungsvorrichtung ($V_{sys}$) an das System gelieferten Spannung und einen Messsensor zum Messen einer Intensität ($I_{batt}$), die von der Batterie an das Anpassungselement geliefert wird.

**Claims**

**1.** A method of estimating **characterized in that** the method is for estimating a ratio real total discharge time divided by theoretical discharge time giving the state of health of a battery (3) in a power supply device for powering a system (S), the power supply device having at least one main power source (1) that nominally powers said system (S), the battery being coupled to said main power source and to said system so as to be capable of powering the system in the event of an interruption of the supply of power from said main power source, the method comprising the steps of:

• voluntarily interrupting (101) the supply of power to the system from the main power source, the battery remaining coupled to the external system in order to power said external system;
• determining (102) the power ($P_{batt}$) delivered from the battery to said system and measuring the voltage ($V_{syst}$) delivered by the battery to said system;
• reestablishing (103) the supply of power to the system from the main power source prior to total discharge of the battery;
• from the delivered power, determining (200, 201) a theoretical total discharge time ($t_{theoretical\_total}$) for the battery; and
• from the voltage measured during the partial discharge, determining (204) a partial discharge curve for the battery and extrapolating (205) said curve in order to deduce therefrom a total discharge curve for the battery and thus estimate the real total discharge time ($t_{real\_total}$) for the battery, the ratio of the real total discharge time divided by the theoretical discharge time giving the state of health of the battery.

**2.** A method according to claim 1, wherein the delivered power ($P_{batt}$) is determined once only at the beginning of discharging the battery (3).

**3.** A method according to claim 1, wherein the supply of power to the system (S) from the main power source (1) is reestablished (103) when the battery voltage ($V_{sys}$) drops below a threshold voltage ($V_{thresh}$).

**4.** A method according to claim 3, further including a step (206) of estimating a partial state of health of the battery (3) by calculating the ratio of the real discharge time for reaching the threshold voltage divided by a theoretical discharge time for reaching said threshold voltage.

**5.** A method according to claim 1, including a prior step (100) of verifying that the voluntarily interruption of the supply of power to the system (S) from the main power source (1) can be initiated.

**6.** A method according to claim 5, wherein the verification step (100) validates initiating the voluntarily interruption of the supply of power to the system (S) from the main power source (1) when the battery (3) is fully charged and/or a temperature of the battery ($T_{batt}$) lies within a given range and/or an ambient temperature ($T_{amb}$) lies within a given range.

7. A method according to claim 1, wherein the theoretical discharge time ($t_{theoretical\_total}$) of the battery (3) is determined by:

> • determining (200) a function giving the discharge time as a function of a delivered power ($P_{batt}$) ; and
> • calculating (201), from said function and from the delivered power ($P_{batt}$), the theoretical total discharge time for the battery ($t_{theoretical\_total}$).

8. A method according to claim 1, further including a step of calculating the lifetime of the battery (3) from said extrapolated curve.

9. A method according to claim 1, including a step of actuating an alarm if the state of health of the battery (3) is less than a given threshold.

10. A method according to claim 1, wherein the power supply device includes a control relay (5) enabling the supply of power to the system (S) from the main power source (1) to be interrupted and that is controlled by a controller (4) of the power supply device, the controller being remotely controlled in order to activate or deactivate the control relay.

11. A power supply device arranged for performing the method according to any preceding claim, the device comprising:

> • the battery (3);
> • an adaptor member (2) coupling the battery both to the main power source (1) and also to the system (S);
> • a control relay (5) enabling the supply of power to the system from the main power source to be interrupted;
> • a controller (4) controlling the control relay, the controller having means for remote communication with a computer (C); and
> • at least one sensor for measuring a voltage ($V_{sys}$) delivered by the power supply device to the system and a sensor for measuring a current ($I_{batt}$) delivered by the battery to the adaptor member.

Fig. 1

Fig. 2

Ordre d'estimation
d'un état de santé
de la batterie

C

Message

100

Non

Décharge
partielle peut être
déclenchée ?

$T_{batt}$

$T_{amb}$

Etat de
charge

Oui

101

Activation du
relais de commande

102

Enregistrements
$I_{batt}$, $V_{sys}$, $P_{batt}$

Non

$V_{sys} \leq V_{seuil}$

Oui

103

Désactivation du
relais de commande

Fig. 3

Fig. 4

Fig. 5

# EP 3 207 387 B1

## RÉFÉRENCES CITÉES DANS LA DESCRIPTION

### Documents brevets cités dans la description

- US 6304471 B, CHALASANI SUBHAS CHANDRA